# EUROPEAN PATENT APPLICATION

(11) **EP 2 472 590 A2**
(43) Date of publication of application: **04.07.2012**
(21) Application number: 11190195.5
(22) Date of filing: 22.11.2011
(51) Int. Cl.: H01L 31/0224, H01L 31/18

(54) **Electrode, photovoltaic device, and method of making**

(30) Priority: 30.11.2010 US 956761
(71) Applicant: General Electric Company, Schenectady, NY 12345 (US)
(72) Inventor: Rojo, Juan Carlos, Niskayuna, NY 12309 (US); Korevaar, Bastiaan Arie, Niskayuna, NY 12309 (US); Cao, Hongbo, Niskayuna, NY 12309 (US); Cao, Jinbo, Niskayuna, NY 12309 (US); Michael, Joseph Darryl, Niskayuna, NY 12309 (US)
(74) Representative: Szary, Anne Catherine

(57) **Abstract**

In one aspect of the present invention, a transparent electrode (100), is presented. The transparent electrode (100) includes a substrate (200) and a transparent layer (300) disposed on the substrate (200). The transparent layer (300) includes (a) a first region (320) including cadmium tin oxide; (b) a second region (340) including tin and oxygen; and (c) a transition region (360) including cadmium, tin, and oxygen interposed between the first region (320) and the second region (340), wherein an atomic ratio of cadmium to tin in the transition region (360) varies across a thickness of the transition region (360). The second region (340) further has an electrical resistivity greater than an electrical resistivity of the first region (32). A photovoltaic device, a photovoltaic module, a method of making is also presented.

## Description

### BACKGROUND

The invention relates to photovoltaic devices with enhanced cell performance and reduced cost of manufacturing. More particularly, the invention relates to transparent electrodes having graded cadmium tin oxide layer for use in photovoltaic devices.

Thin film solar cells or photovoltaic devices typically include a plurality of semiconductor layers disposed on a transparent substrate, wherein one layer serves as a window layer and a second layer serves as an absorber layer. The window layer allows the penetration of solar radiation to the absorber layer, where the optical energy is converted to usable electrical energy. Cadmium telluride/cadmium sulfide (CdTe/CdS) heterojunction-based photovoltaic cells are one such example of thin films solar cells

Typically, a thin layer of transparent conductive oxide (TCO) is deposited between the substrate and the window layer (for example, CdS) to function as a front contact current collector. However conventional TCOs, such as tin oxide, indium tin oxide, and zinc oxide, have high electrical resistivities at thickness necessary for good optical transmission. The use of cadmium tin oxide (CTO) as TCO provides better electrical, optical, and mechanical properties, as well as stability at elevated temperatures. However, CTO/CdS-based thin film solar cells still have challenges, for example, thick CdS films typically result in low device efficiencies whereas thin CdS films lead to reduced open circuit voltage (V_{OC}).

In some instances, to achieve high device efficiencies with thin CdS films, a thin layer of a buffer material, such as a tin oxide (SnO2) layer, is intercalated between the cadmium tin oxide (CTO) and the window (CdS) layers. The typical method used to manufacture the CTO layer includes depositing a layer of amorphous cadmium tin oxide on a substrate, followed by slow thermal annealing of the CTO layer, which is in contact with a CdS film, to achieve desired transparency and resistivity. However, CdS-based annealing of CTO is difficult to implement in a large-scale manufacturing environment. Further, the use of expensive CdS increases the cost of manufacturing. After crystallization of CTO is achieved, a separate buffer layer (for example, tin oxide) is deposited on the CTO layer, which may be further followed by a second annealing step to obtain good crystalline quality. The performance of the buffer layer usually depends in part on the crystallinity and morphology of that layer and is affected by the surface of the CTO on which it is deposited. A high quality buffer layer is desirable to obtain the desired performance in the solar cells manufactured therefrom.

Thus, there is a need to provide improved electrodes and photovoltaic devices manufactured from CTO and buffer layers having desired electrical and optical properties. Further, there is a need to reduce the number of steps for depositing and annealing of CTO and buffer layers during manufacturing of photovoltaic devices, resulting in reduced costs and improved manufacturing capability.

### BRIEF DESCRIPTION OF THE INVENTION

Embodiments of the present invention are provided to meet these and other needs. One embodiment is a transparent electrode. The transparent electrode includes a substrate and a transparent layer disposed on the substrate. The transparent layer includes (a) a first region including cadmium tin oxide; (b) a second region including tin and oxygen; and (c) a transition region including cadmium, tin, and oxygen interposed between the first region and the second region, wherein an atomic ratio of cadmium to tin in the transition region varies across a thickness of the transition region. The second region has an electrical resistivity greater than an electrical resistivity of the first region.

One embodiment is a photovoltaic device. The photovoltaic device includes a substrate; a transparent layer disposed on the substrate; a first semiconductor layer disposed on the transparent layer; a second semiconductor layer disposed on the first semiconductor layer; and a back contact layer disposed on the second semiconductor layer. The transparent layer includes (a) a first region including cadmium tin oxide, (b) a second region including tin and oxygen, and (c) a transition region including cadmium, tin, and oxygen interposed between the first region and the second region, wherein an atomic ratio of cadmium to tin in the transition region varies across a thickness of the transition region. The second region has an electrical resistivity greater than an electrical resistivity of the first region.

One embodiment is a photovoltaic module including a plurality of photovoltaic devices as described above.

Another embodiment is a method. The method includes disposing a substantially amorphous cadmium tin oxide layer on a substrate and thermally processing the substantially amorphous cadmium tin oxide layer to form a transparent layer, wherein thermally processing includes heating the substantially amorphous cadmium tin oxide layer at a treatment temperature, under vacuum conditions, and for a time duration sufficient to allow formation of (a) a first region including cadmium tin oxide, (b) a second region including tin and oxygen, and (c) a transition region including cadmium, tin, and oxygen interposed between the first region and the second region, wherein an atomic ratio of cadmium to tin in the transition region varies across a thickness of the transition region. The second region has an electrical resistivity greater than an electrical resistivity of the first region.

### DRAWINGS

These and other features, aspects, and advantages of the present invention will become better understood when the following detailed description is read with reference to the accompanying drawings, wherein:
FIG. 1 is a schematic of a transparent electrode, according to one embodiment of the present invention.
FIG. 2 is a schematic of a photovoltaic device, according to one embodiment of the present invention.
FIG. 3 is a schematic of a photovoltaic device, according to one embodiment of the present invention.
FIG. 4A shows the XPS profile of as-deposited amorphous cadmium tin oxide layer.
FIG. 4B shows the XPS profile of crystalline cadmium tin oxide layer annealed in contact with CdS film.
FIG. 5 shows the XRD patterns of a transparent layer, according to an exemplary embodiment of the invention.
FIG. 6 shows the XPS profile of a transparent layer, according to an exemplary embodiment of the invention.
FIG. 7 shows the XPS profile of a transparent layer, according to an exemplary embodiment of the invention.
FIG. 8 shows the XPS profile of a transparent layer, according to an exemplary embodiment of the invention.
FIG. 9 shows the XRD pattern of a transparent layer, according to an exemplary embodiment of the invention.
FIG. 10A shows the micrograph of an un-annealed amorphous cadmium tin oxide layer.
FIG. 10B shows the micrograph of a transparent layer, according to an exemplary embodiment of the invention.
FIG. 10C the micrograph of a transparent layer, according to an exemplary embodiment of the invention.
FIG. 11 shows the effect of time and temperature on the composition of the cadmium tin oxide layer, according to an exemplary embodiment of the invention.

### DETAILED DESCRIPTION

As discussed in detail below, some of the embodiments of the invention provide transparent electrodes and photovoltaic devices having a graded cadmium tin oxide layer. The graded cadmium tin oxide layer may advantageously function as a transparent conductive oxide (TCO) layer and a buffer layer in some embodiments or alternatively facilitate disposing of a crystalline buffer layer in some other embodiments, enabling enhanced crystallization and performance of the buffer layer.

Further, the graded cadmium tin oxide layer of the present invention may substantially eliminate the discontinuous interface between the TCO layer and the buffer layer characteristic of device structures that are fabricated by depositing first the TCO layer and then the buffer layer. Thus, the graded cadmium tin oxide layer may provide for improved adhesion between the TCO layer and the CdS layer and accordingly lower contact resistance and reduce optical losses as compared to a bilayer of buffer layer and TCO. In contrast, a bilayer of TCO layer and a buffer layer may have a higher propensity to accumulate impurities at the interface between the TCO layer and the buffer layer leading to increased defect formation. The graded layer may also relieve stresses at the interface between the TCO layer and CdS, and thus create a lower stress level at the CdS/CdTe interface, where defects contribute to lowering the Voc of these devices. The graded cadmium tin oxide layer may thus provide cost reduction during fabrication of the photovoltaic device and enhanced device performance by decreasing the optical absorption in the window layers, reducing the total optical losses, and optimizing the open-circuit voltage of the device.

Approximating language, as used herein throughout the specification and claims, may be applied to modify any quantitative representation that could permissibly vary without resulting in a change in the basic function to which it is related. Accordingly, a value modified by a term or terms, such as "about", is not limited to the precise value specified. In some instances, the approximating language may correspond to the precision of an instrument for measuring the value.

In the following specification and the claims, the singular forms "a", "an" and "the" include plural referents unless the context clearly dictates otherwise.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances the event or capacity cannot occur ― this distinction is captured by the terms "may" and "may be".

The terms "transparent region", "transparent layer" and "transparent electrode" as used herein, refer to a region, a layer, or an article that allows an average transmission of at least 80% of incident electromagnetic radiation having a wavelength in a range from about 300 nm to about 850 nm. As used herein, the term "disposed on" refers to layers disposed directly in contact with each other or indirectly by having intervening layers therebetween.

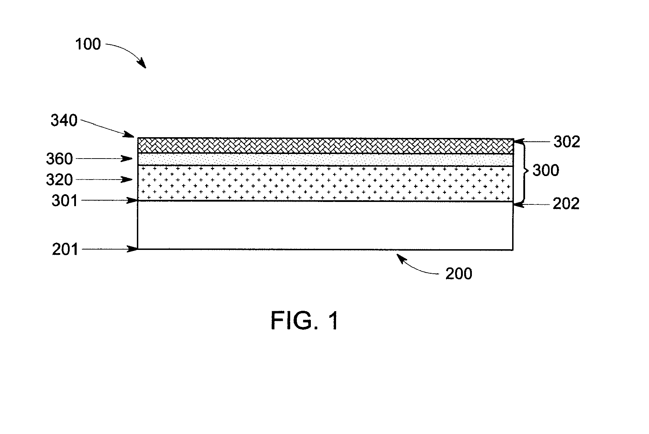

As discussed in detail below, some embodiments of the invention are directed to an improved transparent electrode. A transparent electrode 100 according to one embodiment of the invention is illustrated in FIG. 1. The transparent electrode 100 includes a substrate 200 and a transparent layer 300 disposed on the substrate 200. The transparent layer 300 further includes a first region 320, a second region 340, and a transition region 360 interposed between the first region 320 and the second region 340. The first region 320 includes cadmium tin oxide, the second region 340 includes tin and oxygen, and the transition region 360 includes cadmium, tin, and oxygen, wherein an atomic ratio of cadmium to tin in the transition region 360 varies across a thickness of the transition region 360. The second region 340 has an electrical resistivity that is greater than that an electrical resistivity of the first region 320.

The substrate 200 further includes a first surface 201 and a second surface 202, wherein the solar radiation is incident on the first surface 201 and the transparent layer 300 is disposed adjacent to the second surface 202. In one embodiment, the substrate 200 is transparent over the range of wavelengths for which transmission through the substrate 200 is desired. In one embodiment, the substrate 200 may be transparent to visible light having a wavelength in a range from about 300 nm to about 850 nm. In another embodiment, the substrate 200 further includes a material capable of withstanding heat treatment temperatures greater than about 550 °C. In yet another embodiment, the thermal expansion coefficient of the substrate 200 is close to the thermal expansion coefficient of the transparent layer 300 to prevent cracking or buckling of the transparent layer 300 during heat treatment. Suitable examples of materials for substrate 200 include, but are not limited to, silica and glass. In a particular embodiment, the substrate 200 includes glass. Suitable examples of glass include, but are not limited to, soda-glass and borosilicate glass.

As described above, the transparent layer 300 includes a first region 320 and a second region 340, wherein the second region 340 is more electrically resistive than the first region 320. In some embodiments, the transparent layer 300 includes a graded cadmium tin oxide (CTO) layer wherein the concentration of cadmium and tin in the layer varies across the thickness of the layer. In a particular embodiment, the transparent layer 300 includes a graded cadmium tin oxide (CTO) layer wherein the concentration of cadmium decreases from a first surface of the transparent layer 301 to a second surface 302 of the transparent layer, as illustrated in FIG. 1. In some embodiments, the first region 320 functions as a transparent conductive oxide (TCO) layer and the second region 340 functions as buffer layer. Thus, in some embodiments, the composition of the transparent layer 300 is advantageously engineered to vary across the thickness of the layer such that the transparent layer 300 functions both as a TCO layer and a buffer layer.

The first region 320 in the transparent layer 300 includes cadmium tin oxide. As used herein, the term "cadmium tin oxide" includes a composition of cadmium, tin, and oxygen. In some embodiments, cadmium tin oxide includes a stoichiometric oxide composition of cadmium and tin, wherein, for example, the atomic ratio of cadmium to tin is about 2:1. In some other embodiments, cadmium tin oxide includes a non-stoichiometric oxide composition of cadmium and tin, wherein, for example, the atomic ratio of cadmium to tin is in a range less than about 2:1 or greater than about 2:1. As used herein, the terms "cadmium tin oxide" and "CTO" may be used interchangeably. In some embodiments, cadmium tin oxide may further include dopants, such as, for example, copper, zinc, calcium, yttrium, zirconium, hafnium, vanadium, tin, ruthenium, magnesium, indium, zinc, palladium, rhodium, titanium, or combinations thereof. In certain embodiments, cadmium tin oxide may function as a transparent conductive oxide (TCO). Cadmium tin oxide as a TCO has numerous advantages including superior electrical, optical, surface, and mechanical properties and increased stability at elevated temperatures when compared to tin oxide, indium oxide, indium tin oxide, and other transparent conductive oxides.

The electrical properties of the first region 320 may depend in part on the composition of cadmium tin oxide characterized in some embodiments by the atomic concentration of cadmium and tin, or alternatively in some other embodiments by the atomic ratio of cadmium to tin in cadmium tin oxide. Accordingly, in some embodiments the atomic ratio of cadmium to tin in the first region 320 may be advantageously engineered to provide the desired electrical properties. Atomic ratio of cadmium to tin, as used herein, refers to the ratio of atomic concentration of cadmium to tin in cadmium tin oxide. Atomic concentrations of cadmium and tin and the corresponding atomic ratio are commonly measured using, for instance, x-ray photon spectroscopy (XPS).

In one embodiment, the atomic ratio of cadmium to tin in the first region 320 is in a range from about 1.2:1 to about 3:1. In another embodiment, the atomic ratio of cadmium to tin in the first region 320 is in a range from about 1.4:1 to about 2.5:1. In yet another embodiment, the atomic ratio of cadmium to tin in the first region 320 is in a range from about 1.7:1 to about 2.15:1. In one particular embodiment, the atomic ratio of cadmium to tin in the first region 320 is in a range from about 1.5:1 to about 2:1.

In one embodiment, atomic concentration of cadmium is in a range from about 20% to about 40% of the total atomic content of cadmium tin oxide. In another embodiment, atomic concentration of cadmium is in a range from about 25% to about 35% of the total atomic content of cadmium tin oxide. In a particular embodiment, atomic concentration of cadmium is in a range from about 28% to about 32% of the total atomic content of cadmium tin oxide. In one embodiment, atomic concentration of tin is in a range from about 10% to about 30% of the total atomic content of cadmium tin oxide. In another embodiment, atomic concentration of tin is in a range from about 15% to about 28% of the total atomic content of cadmium tin oxide. In a particular embodiment, atomic concentration of tin is in a range from about 18% to about 24% of the total atomic content of cadmium tin oxide. In one embodiment, atomic concentration of oxygen is in a range from about 30% to about 70% of the total atomic content of cadmium tin oxide. In another embodiment, atomic concentration of oxygen is in a range from about 40% to about 60% of the total atomic content of cadmium tin oxide. In a particular embodiment, atomic concentration of oxygen is in a range from about 44% to about 50% of the total atomic content of cadmium tin oxide.

In one embodiment, the atomic ratio of cadmium to tin in the first region 320 is substantially constant across a thickness of the first region 320. The term "substantially constant" as used herein means that the variation in the atomic ratio of cadmium to tin is less than about 10% across the thickness of the first region 320. The electrical and optical properties of the first region 320 may also depend in part on the thickness of the cadmium tin oxide layer. In one embodiment, the first region 320 has a thickness in a range from about 100 nm to about 500 nm. In another embodiment, the first region 320 has a thickness in a range from about 150 nm to about 450 nm. In a particular embodiment, the first region 320 has a thickness in a range from about 100 nm to about 400 nm. In some embodiments, the higher conductivity of the first region 320 may complement the optical transmission. Higher conductivity or lower resistivity of the first region 320 may allow for a thinner first region 320, which further increases the optical transmission.

As discussed in detail below, the first region 320 is formed by disposing a substantially amorphous cadmium tin oxide layer on the substrate and thermally processing the amorphous cadmium tin oxide layer to form the first region 320 within the transparent layer 300. "Substantially amorphous" as used herein refers to a cadmium tin oxide layer that does not have a crystalline pattern as observed by X-ray diffraction (XRD). In some embodiments, the first region 320 includes a uniform single-phase polycrystalline cadmium tin oxide, formed for example, by annealing the amorphous cadmium tin oxide layer. In some embodiments, the crystalline cadmium tin oxide has an inverse spinel crystal structure. The uniform single-phase crystalline cadmium tin oxide that forms the first region 320 is referred to herein as "cadmium tin oxide" as distinguished from a "substantially amorphous cadmium tin oxide" that is disposed on the substrate 200 and thermally treated to form the transparent layer 300.

The transparent layer 300 further includes a second region 340 including tin and oxygen that is formed by thermal processing of the amorphous cadmium tin oxide layer. The second region 340 may function as a buffer layer in some embodiments or may assist the nucleation of a separately deposited crystalline buffer (for example, tin oxide) layer on the CTO layer resulting in a higher quality buffer layer. In some embodiments, the second region 340 is formed by non-stoichiometric sublimation of cadmium from cadmium tin oxide at annealing conditions employed during thermal processing. Without being bound by theory, it is believed that the vapor pressure of cadmium above the amorphous cadmium tin oxide layer is higher than that of tin, resulting in cadmium depletion at the surface during thermal processing. In some embodiments, controlled depletion of cadmium from the surface results in formation of the second region 340 having controlled thickness, morphology, and composition

As described above with reference to the first region 320, the electrical properties of the second region 340 may also depend in part on the composition of the second region 340 or the concentration of cadmium to tin in the second region 340. In some embodiments, the second region 340 includes tin oxide. In some embodiments the second region 340 further includes cadmium. In one embodiment, the atomic concentration of cadmium in the second region 340 is less than about 10%. In another embodiment, the atomic concentration of cadmium in the second region 340 is less than about 5%. In a particular embodiment, the atomic concentration of cadmium in the second region 340 is less than about 0.5%.

In some other embodiments, the second region 340 is substantially free of cadmium. "Substantially free of cadmium" as used herein means that the atomic concentration of cadmium in the second region 340 is less than about 0.01%. In one embodiment, the atomic concentration of cadmium in the second region 340 is less than about 0.001%. In one embodiment, the atomic concentration of cadmium in the second region 340 is about 0%.

In some embodiments, the atomic ratio of cadmium to tin in the second 340 region is substantially constant across a thickness of the second region 340. As noted earlier, the term "substantially constant" as used herein means that the variation in the atomic ratio of cadmium to tin is less than about 10% across the thickness of the second region 340. In some embodiments, the thickness of the second region 340 is controlled by varying one or more of treatment temperature, time duration, and vacuum conditions employed during the thermal annealing process. In one embodiment, thickness of the second region 340 is engineered to be in a range from about 10 nm to about 300 nm. In another embodiment, the second region 340 has a thickness in a range from about 50 nm to about 250 nm. In a particular embodiment, the second region 340 has a thickness in a range from about 20 nm to about 200 nm.

The transparent layer 300 further includes a transition region 360 interposed between the first region 320 and the second region 340. The transition region 360 includes cadmium, tin and oxygen. As mentioned above, the atomic ratio of cadmium to tin in the transition region 360 varies across the thickness of the transition region 360. In one particular embodiment, the atomic ratio of cadmium to tin in the transition region 360 decreases from the first region 320 to the second region 340.

In some embodiments, the transition region 360 includes a continuous gradient of atomic concentration of cadmium and tin. The continuous gradient of atomic concentrations of cadmium and tin in the transition region 360 allows for continuous transition of composition between the first region 320 (functioning as a transparent conductive oxide (TCO) layer) and the second region 340 (functioning as a buffer layer). Thus, the graded cadmium tin oxide (CTO) layer of the present invention substantially eliminates the discontinuous interface between the TCO layer and the buffer layer characteristic of device structures that are fabricated by depositing first the TCO layer and then the buffer layer. The presence of discontinuous interfaces between functional layers in thin film solar cells may result in both optical and electrical losses.

In some embodiments, the thickness of the transition region 360 is controlled by varying one or more of treatment temperature, time duration, and vacuum conditions employed during the thermal annealing process. In one embodiment, the thickness of the transition region 360 is engineered to be in a range from about 10 nm to about 200 nm. In another embodiment, the transition region 360 has a thickness in a range from about 20 nm to about 150 nm. In a particular embodiment, the transition region 360 has a thickness in a range from about 40 nm to about 100 nm.

The first region 320 and the second region 340 may be further characterized by their electrical and optical properties. In some embodiments, the second region 340 has an electrical resistivity that is greater than the electrical resistivity of the first region 320 by a factor of 1000. In some other embodiments, the second region 340 has an electrical resistivity that is greater than the electrical resistivity of the first region 320 by a factor of 100. In certain embodiments, the second region 340 has an electrical resistivity that is greater than the electrical resistivity of the first region 320 by a factor of 50.

In some embodiments, the first region 320 has an average electrical resistivity (p) that is less than about 2.5 x10⁻⁴ Ohms-cm. In some other embodiments, the first region 320 has an average electrical resistivity (p) that is less than about 2x10⁻⁴ Ohms-cm. In some embodiments, the second region 340 has an average electrical resistivity (p) that is greater about 10⁻³ Ohms-cm. In some embodiments, the second region 340 has an average electrical resistivity (p) that is greater about 10⁻² Ohms-cm. The first region 320 and the second region 340 further have an average optical transmission greater than about 80%. In some embodiments, the transparent electrode 100 has an average optical transmission greater than about 80%. In some other embodiments, the transparent electrode 100 has an average optical transmission greater than about 95%.

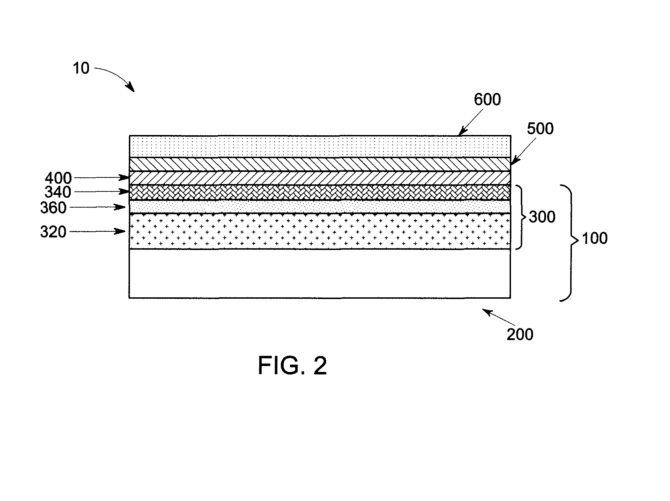

As discussed in detail below, some embodiments of the invention are further directed to improved photovoltaic device designs. A photovoltaic device according to one embodiment of the invention is illustrated in FIG. 2. The photovoltaic device 10 includes a substrate 200, a transparent layer 300 disposed on the substrate 200, a first semiconductor layer 400 disposed on the transparent layer 300, a second semiconductor layer 500 disposed on the first semiconductor layer 400, and a back contact layer 600 disposed on the second semiconductor layer 500. The transparent layer 300 includes a first region 320, a second region 340, and a transition region 360 interposed between the first region 320 and the second region 340.

In some embodiments, the first type semiconductor layer 400 and the second semiconductor layer 500 may be doped with a p-type dopant or n-type dopant to form a heterojunction. As used in this context, a heterojunction is a semiconductor junction, which is composed of layers of dissimilar semiconductor material. These materials usually have non-equal band gaps. As an example, a heterojunction can be formed by contact between a layer or region of one conductivity type with a layer or region of opposite conductivity, e.g., a "p-n" junction. In addition to solar cells, other devices that utilize the heterojunction include thin film transistors and bipolar transistors.

In some embodiments, the second semiconductor layer 500 includes an absorber layer. The absorber layer is a part of a photovoltaic device where the conversion of electromagnetic energy of incident light (for instance, sunlight) to electron-hole pairs (that is, to electrical current) occurs. A photo-active material is typically used for forming the absorber layer. Suitable photo-active materials include cadmium telluride (CdTe), cadmium zinc telluride (CdZnTe), cadmium magnesium telluride (CdMgTe), cadmium manganese telluride (CdMnTe), cadmium sulfur telluride (CdSTe), zinc telluride (ZnTe), CIS (copper, indium, sulphur), CIGS (copper, indium, gallium, selenium), and combinations thereof. The above-mentioned photo-active semiconductor materials may be used alone or in combination. Further, these materials may be present in more than one layer, each layer having different type of photo-active material or having combinations of the materials in separate layers. In one particular embodiment, the second semiconductor layer 500 or the absorber layer includes cadmium telluride (CdTe) as the photo-active material. CdTe is an efficient photo-active material that is used in thin-film photovoltaic devices. CdTe is relatively easy to deposit and therefore is considered suitable for large-scale production. In one embodiment, the second semiconductor layer has a thickness in a range from about 1500 nm to about 4000 nm.

The first semiconductor layer 400 is disposed adjacent to the second region 340 of the transparent layer 300. In a particular embodiment, the first semiconductor layer 400 includes cadmium sulfide (CdS) and may be referred to as the "window layer". The window layer is typically transparent to a substantial portion of solar radiation entering from the transparent substrate 200. However, the CdS layer may not be completely transparent to solar radiation, especially in the range of shorter wavelength, that is, less than 500 nm. Accordingly, a thin CdS layer may be desirable because the thinner the CdS layer, the greater is the portion of shorter wavelength solar radiation that may be transferred into the CdTe layer to be absorbed and converted into electrical energy. However, thinner CdS layers may have more likelihood of pinholes or other defects, resulting in lower open circuit voltage (V_{oc}) of the photovoltaic device. According to some embodiments of the invention, the graded cadmium tin oxide (CTO) layer may advantageously allow for thinner CdS layer to be used without compromising on the photovoltaic device performance. In such embodiments, the second region 340 may function as a buffer layer or insulating layer between the CdTe and the first region 320 (functioning as TCO) if the CdS has pinholes. Further, the second region 340 may also relieve stress at the interface between the first region 320 (functioning as TCO) and CdS, and thus create a lower stress level at the CdS/CdTe interface, where defects contribute to lowering the Voc of these devices. Accordingly, the second region 340 within the transparent layer 300 may obviate the need to dispose an additional buffer layer between the CTO layer and the first semiconductor layer 400 (for example, CdS) in certain embodiments. In one embodiment, the first semiconductor layer 400 has a thickness in a range from about 30 nm to about 150 nm.

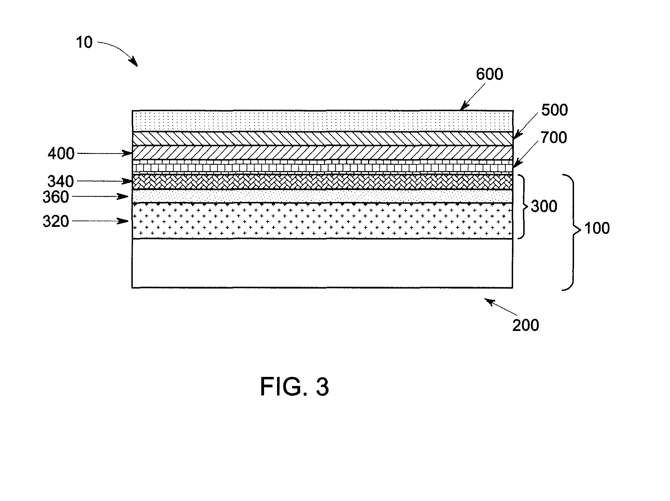

In some embodiments, the photovoltaic device further includes a buffer layer disposed between the transparent layer and the first semiconductor layer. In such embodiments, the buffer layer is disposed adjacent to the second region 340 such that the second region 340 facilitates disposing of higher quality buffer layer on the cadmium tin oxide (CTO) layer and further reduces the effect of discontinuous interface between the cadmium tin oxide (CTO) layer and the buffer layer. As illustrated in FIG. 3, the photovoltaic device 10 includes a substrate 200, a transparent layer 300 disposed on the substrate 200, a first semiconductor layer 400 disposed on the transparent layer 300, a second semiconductor layer 500 disposed on the first semiconductor layer 400, and a back contact layer 600 disposed on the second semiconductor layer 500. The transparent layer 300 includes a first region 320, a second region 340, and a transition region 360 interposed between the first region 320 and the second region 340. The photovoltaic device 10 further includes a buffer layer 700 disposed adjacent to the second region 340 and interposed between the transparent layer 300 and the first semiconductor layer 400.

In one embodiment, the buffer layer 700 includes an oxide selected from the group consisting of tin oxide, indium oxide, zinc oxide, zinc stannate, and combinations thereof. In a particular embodiment, the buffer layer 700 includes tin oxide or ternary mixed oxide thereof.

A back contact layer 600 is further disposed adjacent to the second semiconductor layer 500 and is in ohmic contact therewith. Back contact layer 600 may include a metal, semiconductor, or combination thereof. In some embodiments, a back contact layer 600 may include gold, platinum, molybdenum, or nickel, or zinc telluride. In some embodiments, one or more additional layers may be interposed between the second semiconductor layer 500 and the back contact layer 600, such as, for example, a p+-type semiconductor layer. In some embodiments, the second semiconductor layer 500 may include p-type cadmium telluride (CdTe) that may be further treated or doped to improve the back contact resistance, such as for example, by cadmium chloride treatment or by forming a zinc telluride or copper telluride layer on the backside. In one embodiment, the back contact resistance may be improved by increasing the p type carriers in the CdTe material to form a p+ type layer on the backside of the CdTe material that is in contact with the back contact layer.

In one embodiment, a photovoltaic module is provided. The photovoltaic module may have an array of a number of photovoltaic devices described above electrically connected in series or in parallel. Substantially all photovoltaic devices include the transparent electrode 100 as discussed in above embodiments.

In one embodiment, a method of making the transparent electrode 100 is provided. The method includes disposing a substantially amorphous cadmium tin oxide layer on a substrate 200; and thermally processing the amorphous cadmium tin oxide layer to form a transparent layer 300. Thermal processing of the amorphous cadmium tin oxide layer includes heating the substantially amorphous cadmium tin oxide layer at a treatment temperature, under vacuum conditions, and for time duration sufficient to allow formation of the first region 320, the second region 340, and the transition region 360.

In one embodiment, the substantially amorphous cadmium tin oxide layer is deposited on the substrate 200 by any suitable technique, such as sputtering, chemical vapor depositing, spin coating, spray coating, or dip coating. In one embodiment, the substantially amorphous cadmium tin oxide layer may be formed by dipping a substrate 200 into a solution of a reaction product containing cadmium and tin derived from a cadmium compound and a tin compound.

In a particular embodiment, the substantially amorphous cadmium tin oxide layer is deposited on the substrate 200 by sputtering. In one embodiment, the substantially amorphous cadmium tin oxide layer may be deposited on the substrate by 200 radio frequency (RF) sputtering or direct current (DC) magnetron sputtering. In one embodiment, the substantially amorphous cadmium tin oxide layer may be deposited by reactive sputtering in the presence of oxygen.

In some embodiments, the substantially amorphous cadmium tin oxide layer is disposed on the substrate 200 using a ceramic cadmium tin oxide target. In some other embodiments, a substantially amorphous cadmium tin oxide layer is disposed on the substrate 200 by co-sputtering using cadmium oxide and tin oxide targets or by sputtering from a single target including a blend of cadmium oxide and tin oxide. In some other embodiments, a substantially amorphous cadmium tin oxide layer is disposed on the substrate 200 by reactive sputtering using a single metallic target, wherein the metal target includes a mixture of cadmium and tin metals or by reactive co-sputtering using two different metal targets, that is, a cadmium target and a tin target. The sputtering target(s) may be manufactured, formed, or shaped by any process and in any shape, composition, or configuration suitable for use with any appropriate sputtering tool, machine, apparatus, or system.

When depositing a cadmium tin oxide layer on the substrate 200 by sputtering, the atomic concentration of cadmium and tin in the deposited layer may be directly proportional to the atomic concentration of cadmium and tin in the sputtering target(s). In one embodiment, the atomic ratio of cadmium to tin in the sputtering target(s) is in a range from about 1.2:1 to about 3:1. In another embodiment, the atomic ratio of cadmium to tin in the sputtering target(s) is in a range from about 1.7:1 to about 2.5:1. In one particular embodiment, the atomic ratio of cadmium to tin in sputtering target(s) is in a range from about 1.5:1 to about 2:1. In some embodiments, the atomic concentration of cadmium and tin in the first region 320 of the transparent layer 300 is directly proportional to the atomic concentration of cadmium and tin in the target(s).

The as-deposited cadmium tin oxide layer is substantially amorphous. The amorphous cadmium tin oxide layer is further thermally processed by heating the amorphous cadmium tin oxide layer. In some embodiments, thermally processing the amorphous cadmium tin oxide layer forms a first region 320 that includes cadmium tin oxide having a substantially single-phase spinel crystal structure. As noted herein earlier, the thermal processing step is carried out in the absence of a CdS film or any additional external source of cadmium that is conventionally used for annealing cadmium tin oxide. Accordingly, the thermal processing step of the present invention eliminates the additional step of preparing a CdS film on a substrate 200 that is later used for annealing of cadmium tin oxide. Further, it also reduces the amount of CdS used in the fabrication of a photovoltaic device, and is economically advantageous as CdS is an expensive material.

Thermal processing of the cadmium tin oxide layer is carried out by heating the amorphous cadmium tin oxide layer to further allow for formation of a second region 340 and a transition region 360. As described above, the second region 340 may function as a buffer layer. Accordingly, in some embodiments, the thermal processing step eliminates the need for a separate step for depositing the additional buffer layer thus reducing the cost of fabrication. In some other embodiments, the thermal processing step may provide for an improved interface between the first region 320 (functioning as TCO) and the additional buffer layer by controlling the thickness, morphology, and composition of the second region 340.

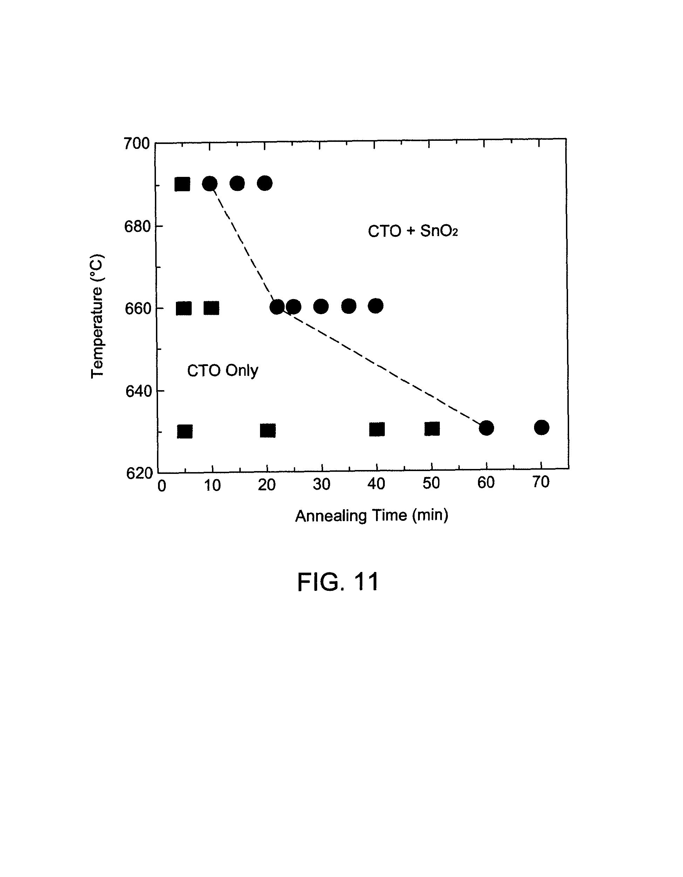

The composition, thickness, and morphology of the first region 320, the second region 340, and the transition region 360 are advantageously controlled by varying one or more of treatment temperature, time duration of heat treatment, and vacuum conditions employed during heat treatment. FIG. 11 illustrates the effect of temperature and time on the composition of thermally treated cadmium tin oxide layers. As noted in FIG. 11 two distinct regions of cadmium tin oxide and tin oxide may be obtained by varying the temperature and time of thermal processing.

In one embodiment, the amorphous cadmium tin oxide layer is heated at the treatment temperature in a range from about 600°C to about 695°C. In another embodiment, the amorphous cadmium tin oxide layer is heated at the treatment temperature in a range from about 620°C to about 680°C. In a particular embodiment, the amorphous cadmium tin oxide layer is heated at the treatment temperature in a range from about 630°C to about 660°C.

In one embodiment, the amorphous cadmium tin oxide layer is heated at the treatment temperature for a time duration in a range from about 1 minute to about 70 minutes. In another embodiment, the amorphous cadmium tin oxide layer is heated at the treatment temperature for a time duration in a range from about 10 minutes to about 60 minutes. In a particular embodiment, the amorphous cadmium tin oxide layer is heated at the treatment temperature for a time duration in a range from about 20 minutes to about 40 minutes.

The composition of the second region 340 may be further controlled by varying the pressure conditions employed during thermal processing. In one embodiment, thermal processing is carried out under vacuum conditions, defmed here in as pressure conditions less than atmospheric pressure. In some embodiments, thermal processing may be carried out in the presence of argon gas at a constant pressure. In some other embodiments, thermal processing may be carried out under dynamic pressure by continuous pumping. In one embodiment, thermal processing is conducted in the presence of argon gas at a pressure less than about 500 Torr. In another embodiment, thermal processing is conducted in the presence of argon gas at a pressure equal to or less than about 250 Torr. In yet another embodiment, thermal processing is conducted in the presence of argon gas at a pressure equal to or less than about 50 Torr. In a particular embodiment, thermal processing is conducted in the presence of argon gas at a pressure equal to or less than about 10⁻³ Torr.

In some embodiments, the first region 320, the second region 340, and the transition region 360 are formed within the transparent layer 300 by sublimation of cadmium from the amorphous cadmium tin oxide layer. In some embodiments, sublimation of cadmium from the cadmium tin oxide layer is non-stoichiometric resulting in a concentration gradient of cadmium within the layer. The concentration gradient is advantageously controlled by varying the thermal processing conditions (temperature, time and vacuum) to form the first region 320, the transition region 360, and the second region 340 within the transparent layer 300.

In one embodiment, the method further includes the steps of disposing a first semiconductor layer 400 on the transparent layer 300 after the step of thermal processing, disposing a second semiconductor layer 500 on the first semiconductor layer 400, and disposing a back contact layer 600 on the second semiconductor layer 500 to form a photovoltaic device 10. In some embodiments, the first semiconductor layer 400 is disposed directly on the transparent layer 300 and an intermediate step of depositing an additional buffer layer is not required. In some other embodiments, an additional buffer layer 700 is disposed on the transparent layer 300 adjacent to the second region 340 after the thermal processing step. In such embodiments, the first 400 semiconductor layer is disposed on the buffer layer 700.

One or more of the first semiconductor layer 400, second semiconductor layer 500, back contact layer 600, or the buffer layer (optional) 700 may be deposited by one or more of the following techniques: sputtering, electrodepositing, screen printing, spraying, physical vapor depositing, or closed space sublimation. One or more of these layers may be further heated or subsequently treated to manufacture the photovoltaic device 10.

### EXAMPLES

The following examples are presented to further illustrate certain embodiments of the present invention. These examples should not be read to limit the invention in any way.

### Example 1 Annealing of cadmium tin oxide using CdS film

Thin films of cadmium tin oxide (CTO) were prepared on a 1.3 mm thick glass substrate by non-reactive magnetron DC sputtering from a pre-reacted cadmium stannate target having a 2:1 Cd:Sn ratio. The sputtering process was performed in an atmosphere containing oxygen and argon (wherein the concentration of oxygen was greater than 90%) at a pressure of about 16 mTorr. The thickness of the sputtered CTO film was in a range from 200 nm to 400nm. Annealing was carried out by placing the CTO films prepared above in contact with a CdS-coated glass substrate (referred to herein as CdS proximity annealing). The assembly was heated to a temperature of 630 °C for about 20 minutes in the presence of argon at a pressure of about 150 Torr.

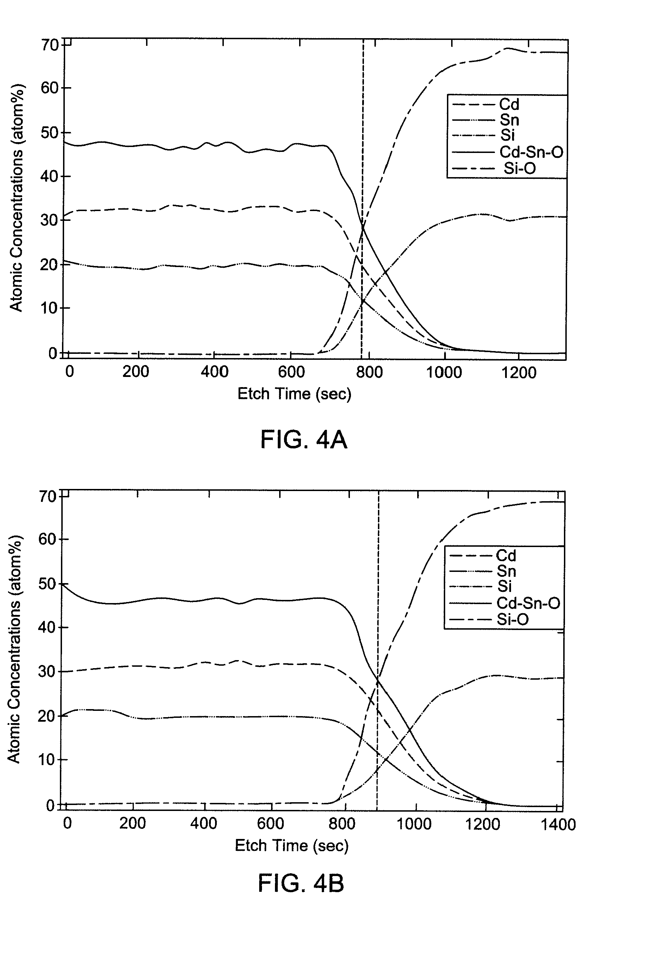

FIG. 4A shows the XPS profile of as-deposited cadmium tin oxide film illustrating that the cadmium to tin atomic ratio is homogeneous across the thickness of the film. FIG. 4B shows the XPS profile of the CdS proximity-annealed cadmium tin oxide film illustrating that there was no change in atomic concentration of cadmium and tin and the corresponding atomic ratio after the annealing step. Further, no gradation in atomic concentration was observed for CTO films annealed using CdS film. As described above, a separate buffer or HRT layer may be deposited on the annealed CTO layer to obtain the desired configuration and performance properties of photovoltaic devices manufactured using these CTO films.

### Example 2 Annealing of cadmium tin oxide without CdS film at different pressures

Thin films of cadmium tin oxide (CTO) were prepared on a glass substrate using the method as described in Example 1. Three CTO samples (0.5 inches x 1 inch) were cut and sealed in 0.75 inches diameter quartz ampoules. The ampoules were filled with argon gas at three different vacuum levels: 10⁻⁵ Torr, 50 Torr, and 250 Torr, respectively. These samples were then annealed at 630 °C for about 20 minutes.

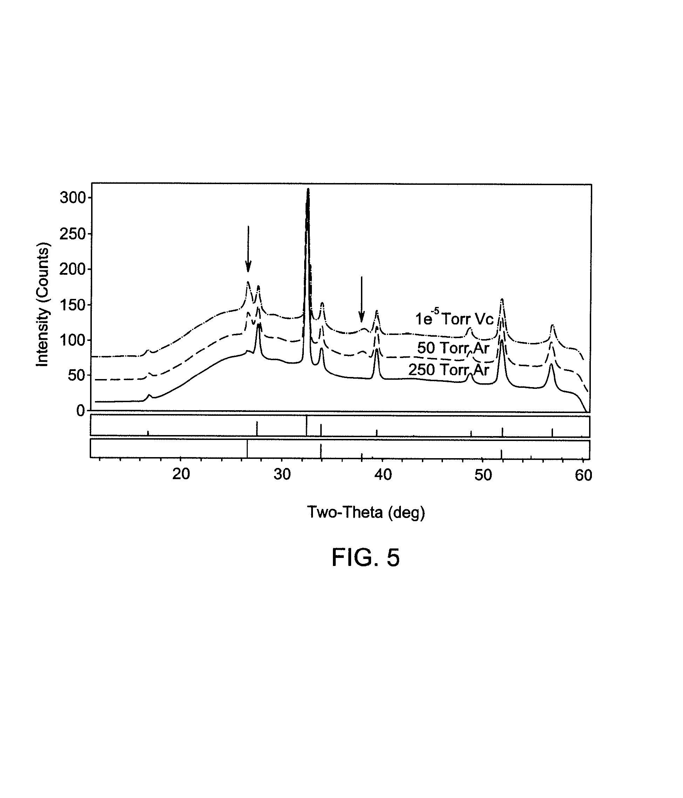

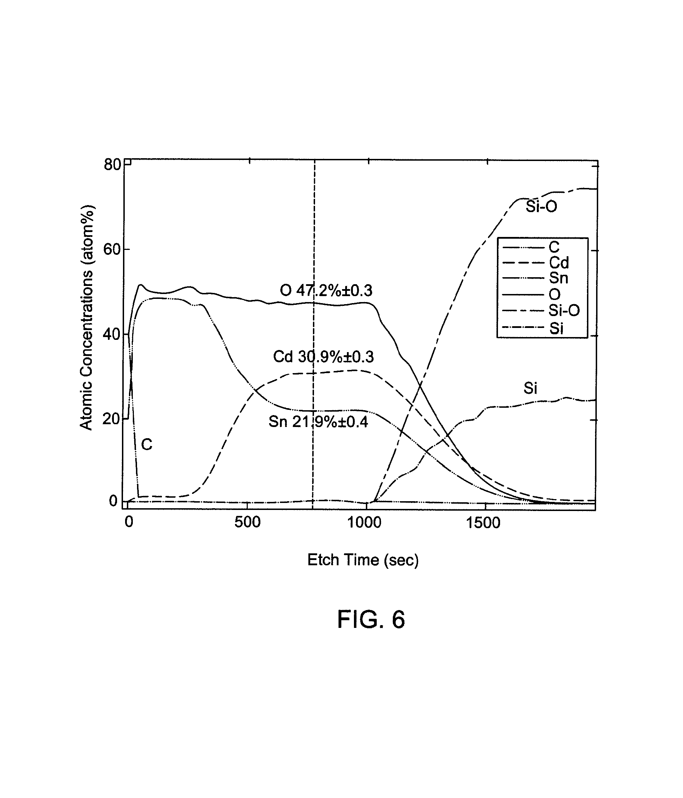

FIG. 5 shows the X-ray diffraction patterns obtained from the three set of samples annealed at three different pressures indicate clear presence of tin oxide peaks (marked by arrows) for the samples sealed under vacuum at 10⁻⁵ Torr and at 50 Torr. FIG. 6 shows the XPS profile of cadmium tin oxide film annealed under vacuum at 10⁻⁵ Torr. FIG. 6 illustrates that after annealing, the CTO film showed three different concentration profiles: (a) a first region showing a constant atomic ratio of cadmium to tin for etch times in the range of about 600 seconds to about 1000 seconds; (b) a substantially cadmium-depleted region for etch times in the range of 0 second to about 300 seconds; and (c) a transition region for etch times in the range of 300 seconds to about 600 seconds in which the atomic concentration of cadmium and tin varies across the thickness of the transition region. As illustrated in FIG. 6, the first region had the same atomic ratio of cadmium to tin as observed for the as-deposited amorphous cadmium tin oxide film (FIG. 4A). Further, the XPS profile in FIG. 6 confirmed the presence of a substantially cadmium-free region having a thickness of about 50 nm after the annealing step. As described above, the substantially cadmium-free region may function as the buffer layer in some embodiments of the invention thus obviating the need for a separate step of depositing a buffer layer on the CTO layer. In such instances a first semiconductor layer of CdS may be deposited directly on the annealed CTO layer. In some other embodiments, the substantially cadmium-free region may provide a better interface between the annealed CTO layer and the additional buffer layer disposed on the CTO layer, enabling enhanced crystallization and performance of the buffer layer.

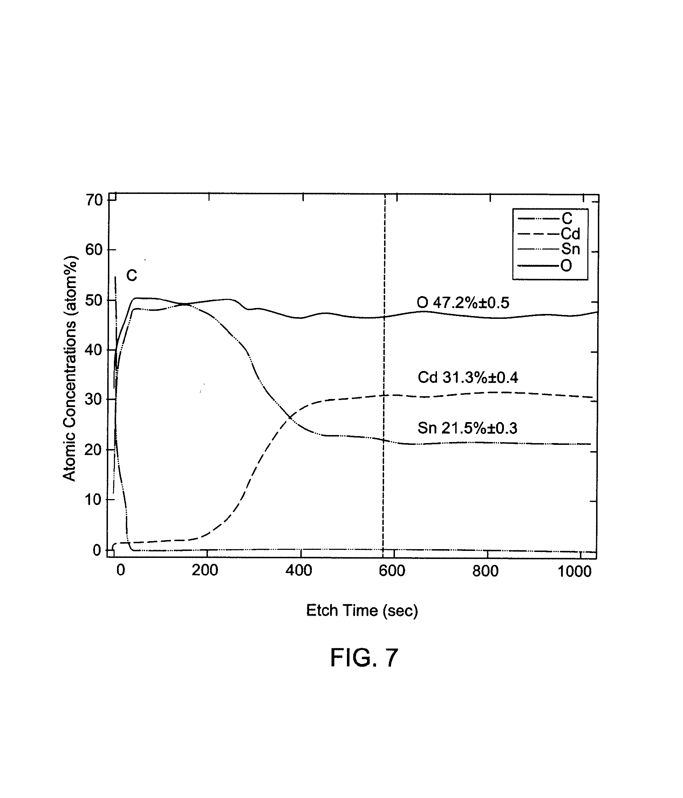

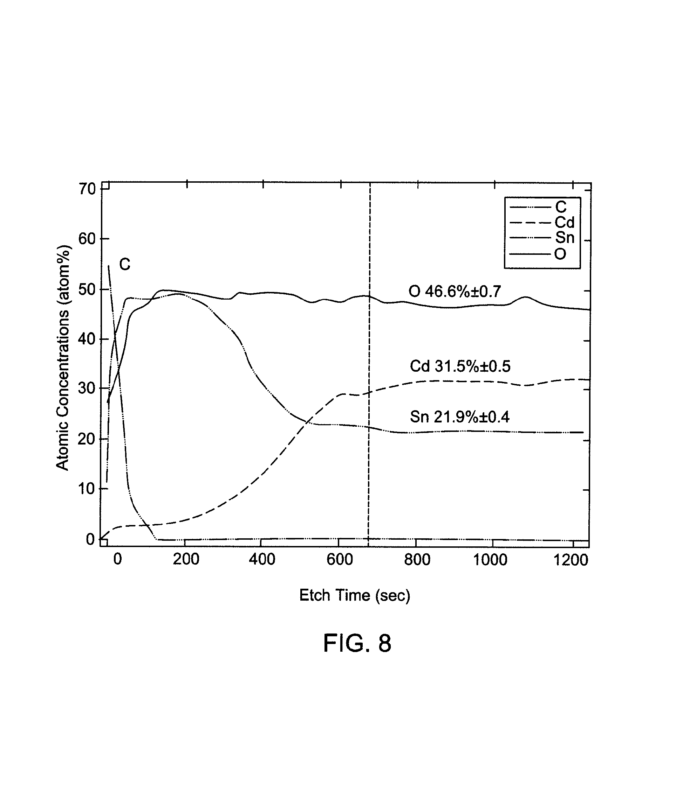

FIG. 7 and FIG. 8 show the XPS profiles of cadmium tin oxide films annealed at a pressure of 50 Torr and 250 Torr, respectively. Similar to FIG. 6, the XPS profiles in FIG. 7 and FIG.8 illustrate the formation of three different concentration profiles of cadmium and tin. A substantially cadmium-free region of about 50 nm was observed for sample annealed at 50 Torr as seen in FIG. 7. FIG. 8 also illustrates severe depletion of cadmium in the first 50 nm of the film. However, the presence of cadmium at an atomic concentration less than about 5% is also observed throughout the surface of the film. This indicates that the atomic ratio and thickness of the tin-oxide rich region (second region) may be modified by varying the annealing pressure conditions.

### Example 3 Annealing of cadmium tin oxide without CdS film at different temperatures and for different time duration.

Thin films of cadmium tin oxide (CTO) were prepared on a glass substrate using the method as described in Example 1. The films were annealed at 660 °C under continuous pumping (vacuum) at a pressure below 10⁻³ Torr for time duration in a range of 10 minutes to 40 minutes.

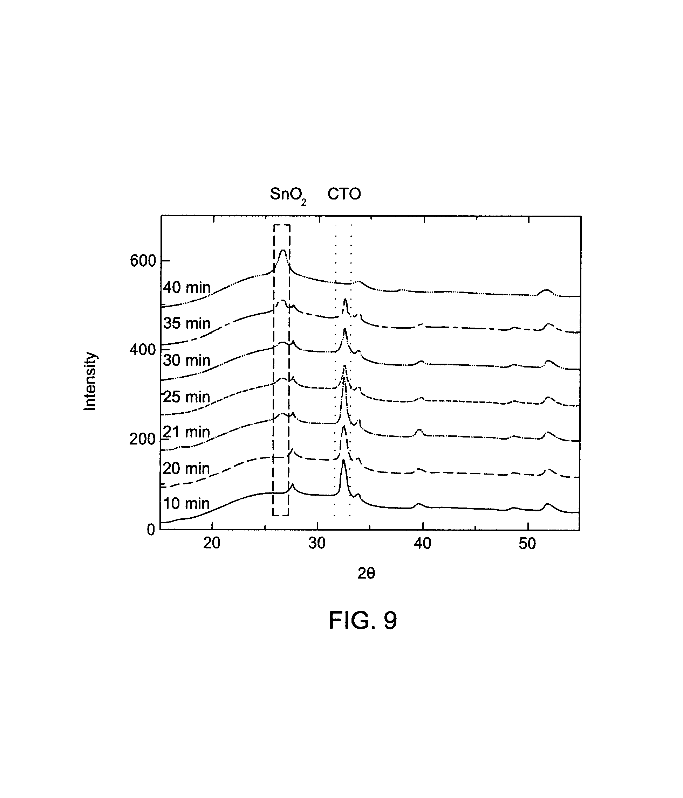

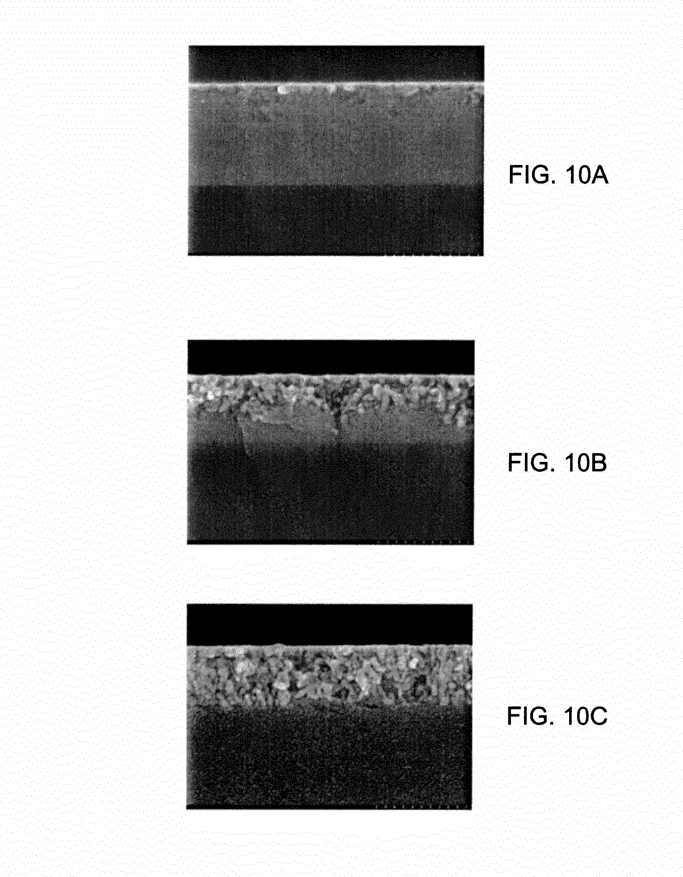

FIG. 9 shows the XRD pattern for the CTO films annealed for different time durations. As illustrated in FIG. 9, tin oxide peaks are observed more prominently as the annealing time duration increases from 10 minutes to 40 minutes. FIG. 10A shows the scanning electron microscopy (SEM) micrograph for an un-annealed CTO film. Figs 10B and 10C show the scanning electron microscopy (SEM) micrographs for CTO films annealed for 25 minutes and 40 minutes, respectively. As illustrated in FIG. 10B after 25 minutes, a tin-oxide rich surface was observed. FIG. 10C illustrates that after 40 minutes of annealing cadmium is completely removed from the film. FIG. 11 shows an annealing time -temperature phase diagram for CTO films. As indicated in FIG. 11, different combinations of annealing temperatures and times result in tin oxide-rich region (second region). Further, as described above, the atomic concentration and thickness of the tin oxide-rich region (second region) may be modified by varying one or both of annealing temperature or time duration of annealing.

The foregoing examples are merely illustrative, serving to exemplify only some of the features of the invention. The appended claims are intended to claim the invention as broadly as it has been conceived and the examples herein presented are illustrative of selected embodiments from a manifold of all possible embodiments. Accordingly, it is the Applicants' intention that the appended claims are not to be limited by the choice of examples utilized to illustrate features of the present invention. As used in the claims, the word "comprises" and its grammatical variants logically also subtend and include phrases of varying and differing extent such as for example, but not limited thereto, "consisting essentially of" and "consisting of." Where necessary, ranges have been supplied; those ranges are inclusive of all sub-ranges there between. It is to be expected that variations in these ranges will suggest themselves to a practitioner having ordinary skill in the art and where not already dedicated to the public, those variations should where possible be construed to be covered by the appended claims. It is also anticipated that advances in science and technology will make equivalents and substitutions possible that are not now contemplated by reason of the imprecision of language and these variations should also be construed where possible to be covered by the appended claims.

Various aspects and embodiments of the present invention are defined by the following numbered clauses:
1. A transparent electrode, comprising:
   a substrate; and
   a transparent layer disposed on the substrate, wherein the transparent layer comprises:
      (a) a first region comprising cadmium tin oxide,
      (b) a second region comprising tin and oxygen, and
      (c) a transition region comprising cadmium, tin, and oxygen interposed between the first region and the second region, wherein an atomic ratio of cadmium to tin in the transition region varies across a thickness of the transition region,
   wherein the second region has an electrical resistivity greater than an electrical resistivity of the first region.
2. The transparent electrode of clause 1, wherein an atomic ratio of cadmium to tin in the first region is in a range from about 1.2:1 to about 3:1.
3. The transparent electrode of clause 1, wherein an atomic ratio of cadmium to tin in the first region is in a range from about 1.5: 1 to about 2:1.
4. The transparent electrode of clause 1, wherein an atomic ratio of cadmium to tin in the first region is substantially constant across a thickness of the first region.
5. The transparent electrode of clause 1, wherein the first region has a thickness in a range from about 100 nm to about 400 nm.
6. The transparent electrode of clause 1, wherein the cadmium tin oxide has a substantially single-phase spinel crystal structure.
7. The transparent electrode of clause 1, wherein the second region has a thickness in a range from about 20 nm to about 200 nm.
8. The transparent electrode of clause 1, wherein the second region further comprises cadmium and an atomic concentration of cadmium is less than about 5%.
9. The transparent electrode of clause 1, wherein the second region further comprises cadmium and an atomic concentration of cadmium is less than about 0.5%.
10. The transparent electrode of clause 1, wherein the second region is substantially free of cadmium.
11. The transparent electrode of clause 1, wherein the transition region has a thickness in a range from about 40 nm to about 100 nm.
12. The transparent electrode of clause 1, wherein the atomic ratio of cadmium to tin in the transition region decreases from the first region to the second region.
13. The transparent electrode of clause 1, wherein the first region has an electrical resistivity less than about 2 x 10⁻⁴ Ohms-cm.
14. The transparent electrode of clause 1, wherein the second region has an electrical resistivity greater than about 10⁻² Ohms-cm.
15. The transparent electrode of clause 1, wherein the transparent electrode has an average optical transmission greater than about 80%.
16. A photovoltaic device, comprising:
   a substrate;
   a transparent layer disposed on the substrate;
   a first semiconductor layer disposed on the transparent layer;
   a second semiconductor layer disposed on the first semiconductor layer; and
   a back contact layer disposed on the second semiconductor layer; wherein the transparent layer comprises:
      (a) a first region comprising cadmium tin oxide,
      (b) a second region comprising tin and oxygen, and
      (c) a transition region comprising cadmium, tin, and oxygen interposed between the first region and the second region, wherein an atomic ratio of cadmium to tin in the transition region varies across a thickness of the transition region,
   wherein the second region has an electrical resistivity greater than an electrical resistivity of the first region.
17. The photovoltaic device of clause 16, wherein the first semiconductor layer comprises cadmium sulfide.
18. The photovoltaic device of clause 16, wherein the second semiconductor layer comprises cadmium telluride.
19. The photovoltaic device of clause 16, wherein the first semiconductor layer has a thickness in a range from about 30 nm to about 150 nm.
20. The photovoltaic device of clause 16, wherein the second semiconductor layer has a thickness in a range from about 1500 nm to about 4000 nm.
21. The photovoltaic device of clause 16, wherein the photovoltaic device further comprises a buffer layer interposed between the transparent layer and the first semiconductor layer.
22. The photovoltaic device of clause 21, wherein the buffer layer comprises an oxide selected from the group consisting of tin oxide, indium oxide, zinc oxide, and combinations thereof
23. A photovoltaic module comprising a plurality of photovoltaic devices as defined in clause 16.
24. A method, comprising:
   disposing a substantially amorphous cadmium tin oxide layer on a substrate; and
   thermally processing the substantially amorphous cadmium tin oxide layer to form a transparent layer, wherein thermally processing comprises heating the amorphous cadmium tin oxide layer at a treatment temperature, under vacuum conditions, and for a time duration sufficient to allow formation of:
      (a) a first region comprising cadmium tin oxide,
      (b) a second region comprising tin and oxygen, and
      (c) a transition region comprising cadmium, tin, and oxygen interposed between the first region and the second region, wherein an atomic ratio of cadmium to tin in the transition region varies across a thickness of the transition region,
   wherein the second region has an electrical resistivity greater than an electrical resistivity of the first region.
25. The method of clause 24, wherein thermally processing comprises non-stoichiometric sublimation of cadmium from the substantially amorphous cadmium tin oxide layer.
26. The method of clause 24, wherein thermally processing comprises heating the substantially amorphous cadmium tin oxide layer at the treatment temperature in a range from about 600°C to about 695°C.
27. The method of clause 24, wherein thermally processing is conducted in the presence of argon gas at a pressure less than about 500 Torr.
28. The method of clause 24, wherein thermal processing is conducted in the presence of argon gas at a pressure equal to or less than about 10⁻³ Torr.
29. The method of clause 24, wherein thermally processing comprises heating the substantially amorphous cadmium tin oxide layer for a time duration in a range from about 1 minute to about 70 minutes.
30. The method of clause 24, wherein thermally processing comprises forming a first region comprising cadmium tin oxide having a substantially single-phase spinel crystal structure.
31. The method of clause 24, wherein disposing a substantially amorphous cadmium tin oxide layer comprises sputtering, chemical vapor depositing, spin coating, or dip coating.
32. The method of clause 24, further comprising:
   disposing a first semiconductor layer on the transparent layer after the step of thermal processing;
   disposing a second semiconductor layer on the first semiconductor layer; and
   disposing a back contact layer on the second semiconductor layer to form a photovoltaic device.
33. The method of clause 24, further comprising disposing a buffer layer on the transparent layer, wherein the buffer layer is disposed adjacent to the second region.

## Claims

1. A transparent electrode, comprising:
a substrate; and
a transparent layer disposed on the substrate, wherein the transparent layer comprises:
(a) a first region comprising cadmium tin oxide,
(b) a second region comprising tin and oxygen, and
(c) a transition region comprising cadmium, tin, and oxygen interposed between the first region and the second region, wherein an atomic ratio of cadmium to tin in the transition region varies across a thickness of the transition region,
wherein the second region has an electrical resistivity greater than an electrical resistivity of the first region.

2. The transparent electrode of claim 1, wherein an atomic ratio of cadmium to tin in the first region is in a range from about 1.2:1 to about 3:1.

3. The transparent electrode of claim 1 or claim 2, wherein an atomic ratio of cadmium to tin in the first region is substantially constant across a thickness of the first region.

4. The transparent electrode of any preceding claim, wherein the first region has a thickness in a range from about 100 nm to about 400 nm.

5. The transparent electrode of any preceding claim, wherein the cadmium tin oxide has a substantially single-phase spinel crystal structure.

6. The transparent electrode of any preceding claim, wherein the second region has a thickness in a range from about 20 nm to about 200 nm.

7. The transparent electrode of any preceding claim, wherein the second region further comprises cadmium and an atomic concentration of cadmium is less than about 5%.

8. The transparent electrode of any preceding claim, wherein the second region further comprises cadmium and an atomic concentration of cadmium is less than about 0.5%.

9. The transparent electrode of any preceding claim, wherein the transition region has a thickness in a range from about 40 nm to about 100 nm.

10. The transparent electrode of any preceding claim, wherein the atomic ratio of cadmium to tin in the transition region decreases from the first region to the second region.

11. A photovoltaic device, comprising:
a substrate;
a transparent layer disposed on the substrate;
a first semiconductor layer disposed on the transparent layer;
a second semiconductor layer disposed on the first semiconductor layer; and
a back contact layer disposed on the second semiconductor layer; wherein the transparent layer comprises:
(a) a first region comprising cadmium tin oxide,
(b) a second region comprising tin and oxygen, and
(c) a transition region comprising cadmium, tin, and oxygen interposed between the first region and the second region, wherein an atomic ratio of cadmium to tin in the transition region varies across a thickness of the transition region,
wherein the second region has an electrical resistivity greater than an electrical resistivity of the first region.

12. The photovoltaic device of claim 11, wherein the first semiconductor layer comprises cadmium sulfide.

13. The photovoltaic device of claim 11 or claim 12, wherein the second semiconductor layer comprises cadmium telluride.

14. The photovoltaic device of any one of claims 11 to 13, wherein the photovoltaic device further comprises a buffer layer interposed between the transparent layer and the first semiconductor layer.

15. A method, comprising:
disposing a substantially amorphous cadmium tin oxide layer on a substrate; and
thermally processing the substantially amorphous cadmium tin oxide layer to form a transparent layer, wherein thermally processing comprises heating the amorphous cadmium tin oxide layer at a treatment temperature, under vacuum conditions, and for a time duration sufficient to allow formation of:
(a) a first region comprising cadmium tin oxide,
(b) a second region comprising tin and oxygen, and
(c) a transition region comprising cadmium, tin, and oxygen interposed between the first region and the second region, wherein an atomic ratio of cadmium to tin in the transition region varies across a thickness of the transition region,
wherein the second region has an electrical resistivity greater than an electrical resistivity of the first region.
